# EUROPÄISCHE PATENTSCHRIFT

(11) **EP 3 469 621 B1**
(45) Veröffentlichungstag und Bekanntmachung des Hinweises auf die Patenterteilung: **17.08.2022**
(21) Anmeldenummer: 17730160.3
(22) Anmeldetag: 14.06.2017
(51) Int. Cl.: H01J 37/32, H01L 21/67, H05B 41/32

(54) **VERFAHREN UND VORRICHTUNG ZUR THERMISCHEN BEHANDLUNG EINES SUBSTRATS**
METHOD AND APPARATUS FOR THE THERMAL TREATMENT OF A SUBSTRATE
PROCÉDÉ ET DISPOSITIF DE TRAITEMENT THERMIQUE D'UN SUBSTRAT

(30) Priorität: 14.06.2016 DE 102016110867; 13.07.2016 DE 102016112836
(43) Veröffentlichungstag der Anmeldung: 17.04.2019
(73) Patentinhaber: Gross, Leander Kilian, 01465 Langebrück (DE); Gross, Mascha Elly, 01465 Langebrück (DE)
(72) Erfinder: GROSS, Harald, 01465 Langebrück (DE)
(74) Vertreter: Lippert Stachow Patentanwälte Rechtsanwälte Partnerschaft mbB
(86) Internationale Anmeldenummer: PCT/EP2017/064616
(87) Internationale Veröffentlichungsnummer: WO 2017/216262

(56) Entgegenhaltungen:
- US-A- 4 325 008
- US-A1- 2007 235 662
- US-A1- 2010 098 874
- US-A1- 2010 111 513
- US-A1- 2013 043 221
- US-A1- 2013 099 693

## Beschreibung

Die Erfindung betrifft ein Verfahren und eine Vorrichtung zur kurzzeitigen thermischen Behandlung eines Substrats mittels mindestens einer Gasentladungslampe. Anwendung findet das Verfahren in den verschiedensten Bereichen der Industrie wie beispielsweise in der Halbleiterproduktion, der Fabrikation von Photovoltaik-Modulen oder der Displayherstellung. Zu neuartigen Anwendungsgebieten gehören unter anderem gedruckte Elektronik oder Beschichtungen von Oberflächen mit Nanopartikeln. Aufgrund der kurzen Dauer der thermischen Behandlung werden beispielsweise Diffusionsvorgänge minimiert und Aufheiz- bzw. Abkühlstrecken vermieden wie sie bei Öfen in industriellen Durchlaufanlagen üblich sind.

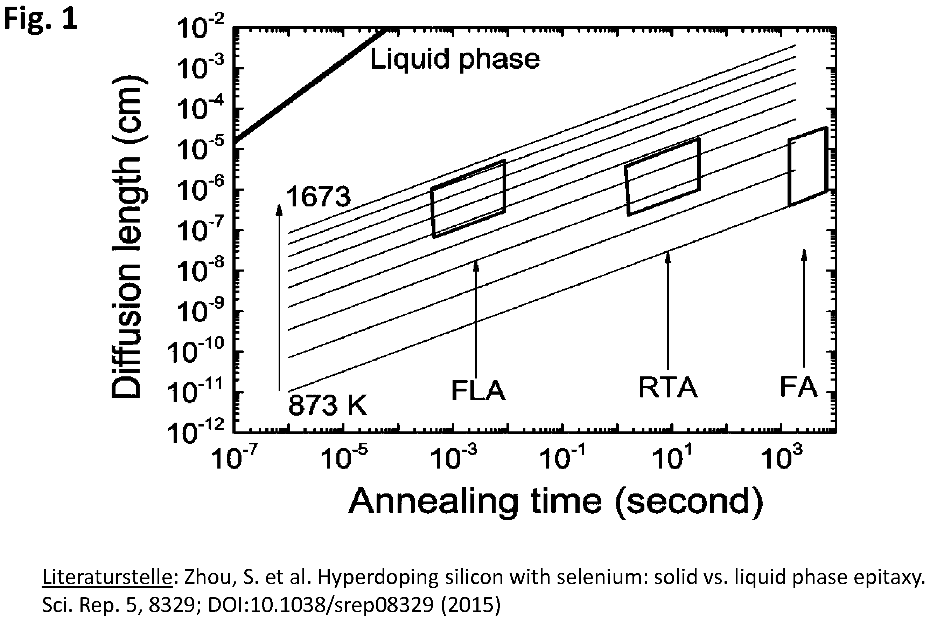

Figur 1 zeigt die zeitliche Dauer der thermischen Behandlung verschiedener Verfahren für die Dotierung eines Halbleiters. Dazu gehört die thermische Behandlung mit Blitzlampen (FLA:= Flash Lamp Annealing), mit Halogen- bzw. Infrarotlampen (RTA:= Rapid Thermal Annealing) und die thermische Behandlung in Öfen (FA:= Furnace Annealing).

Bei Experimenten und thermischen Simulationen hat sich herausgestellt, dass je nach Anwendung das eine oder andere Verfahren oder eine Kombination davon zur thermischen Behandlung geeignet ist. Beispielsweise wird beim sogenannten "Photonic Curing" in einem ersten Prozessschritt eine kupferhaltige Tinte auf eine Kunststofffolie gedruckt, in einem zweiten Prozessschritt mittels eines Infrarotstrahlers bei einer Temperatur von ca. 120 Grad Celsius innerhalb ungefähr einer Sekunde getrocknet und in einem dritten Prozessschritt mit Hilfe von Blitzlampen bei über 800 Grad Celsius eine Millisekunde lang gesintert. Der Sinterprozess kann aufgrund der maximalen Betriebstemperatur des Kunststoffs weder mit Infrarotstrahlern, noch in einem konventionellen Ofen durchgeführt werden. Der Trocknungsprozess hingegen benötigt eine gewisse Zeit u.a. in Abhängigkeit von der Dicke des Films bis die in der gedruckten Tinte enthaltene Lösungsmittel verdampft sind. Diese Trocknungszeit liegt ein bis mehrere Größenordnungen über der in der Praxis möglichen Pulsdauer von Blitzlampen. Prinzipiell könnte man bei Durchlaufanlagen die Einwirkungsdauer des Infrarotstrahlers bzw. der Halogenlampe auf das Substrat durch eine hohe Relativgeschwindigkeit zueinander auch im Bereich einer Millisekunde einstellen. Aber die maximal möglichen Leistungen von Infrarotstrahlern oder Halogenlampen liegen mehrere Größenordnungen unterhalb der für den raschen Temperaturanstieg auf 800 Grad Celsius erforderlichen Leistungen.

In der Halbleiterindustrie ist RTA mit Hilfe von Halogenlampen, z.B. zur Aktivierung von Dotanden nach der Implantation oder zur Oxidation von Oberflächen in Sauerstoff ein fester Bestandteil in der Produktion. Um höhere Temperaturen auf der Substratoberfläche erreichen zu können werden in manchen Fällen Blitzlampen zusätzlich zu den Halogenlampen eingesetzt. Nach der vollständigen Erwärmung eines gesamten Wafers mit Halbleitern innerhalb beispielsweise einer bis weniger Sekunden auf 900 Grad Celsius mit Hilfe der Halogenlampen findet direkt danach eine thermische Behandlung mit Blitzlampen statt, um kurzzeitig eine maximale Oberflächentemperatur von ca. 1300 Grad Celsius zu erreichen. Mit vollständiger Erwärmung durch die Halogenlampen ist ein vernachlässigbarer Temperaturgradient innerhalb des gesamten Wafers gemeint. Die durch die Blitzlampen hervorgerufene zusätzliche Temperaturerhöhung hingegen betrifft nur die ersten wenigen Mikrometer der von den Blitzlampen beleuchteten Seite des Wafers. Die Kombination von Halogenlampen und Blitzlampen wird auch als "flash lamp assisted spike annealing" bezeichnet. Eine längere als mit Blitzlampen verursachte Einwirkungsdauer von Temperaturen im Bereich von 1300 Grad Celsius hätte nachteilige Effekte auf die Diffusionsprofile eines pn-Übergangs in einem Transistor. Eine Erwärmung des Wafers von Raumtemperatur auf 1300 Grad Celsius durch Blitzlampen alleine würde nicht nur übermäßig hohe Temperaturgradienten und damit verbundene thermomechanische Verspannung bis zum Bersten des Wafers führen, sondern die dafür erforderlichen Leistungen liegen je nach Ausführungsform nahe oder auch über der Explosionsgrenze von Blitzlampen.

Wie in Figur 1 zu sehen ist gibt es eine zeitliche Lücke hinsichtlich der thermischen Behandlung zwischen FLA und RTA. Diese Lücke betrifft unter anderem Beschichtungen auf Substraten, die eine Dicke von ungefähr 2 bis etwa 200 Mikrometer aufweisen. Dazu gehören beispielsweise Sol-Gel Filme mit Nanopartikeln oder Lacke. Ebenso ist es von großem Interesse ein Verfahren zu finden, welches geringere Temperaturgradienten innerhalb des Substrats erzeugt gemäß dem "flash lamp assisted spike annealing", aber dabei die Rückseite des Substrats auf Raumtemperatur bleibt. Idealerweise sollte dieses Verfahren mit einer einzigen Art anstelle mehrerer Energiequellen auskommen. Aus Platzgründen werden beim flash lamp assisted spike annealing die Halogenlampen üblicherweise zur Bestrahlung der Rückseite des Wafers angeordnet und die Blitzlampen zur Bestrahlung der Stirnseite, auf denen sich die Transistoren befinden. Diese spezielle Anordnung ist nur aufgrund der vollständigen Erwärmung des Wafers durch die Halogenlampen möglich. Wenn aber eine vollständige Erwärmung des Substrats für die thermische Behandlung vermieden werden muss, d.h. die Rückseite des Substrats eine bestimmte Temperatur nicht überschreiten darf, so können beide Energiequellen nur auf der Stirnseite angeordnet werden. Dies ist u.a. aus Platzgründen oder Beschränkungen hinsichtlich der Lichtoptik nicht immer möglich.

Ein weiterer Nachteil der Halogenlampen oder Infrarotlampen ist die relativ lange Anschalt- bzw. Abschaltdauer. Beispielsweise dauert es ungefähr eine halbe Sekunde bis die Glühwendel der Halogenlampen beim Anschalten bis zur vollen Strahlungsleistung aufgeheizt sind. Bei Blitzlampen hingegen kann die Anschaltdauer im Bereich von einer bis wenigen Mikrosekunden liegen. Für das Verfahren gemäß der Erfindung sollte die Anschalt- und Abschaltdauer für die Energiequelle kürzer als 10% der gesamten Belichtungsdauer sein. Idealerweise ist diese so kurz wie bei Blitzlampen, welche im Bereich von wenigen Mikrosekunden liegt.

Prinzipiell könnten Laser für die in Figur 1 skizzierte zeitliche Lücke zwischen FLA und RTP eingesetzt werden. Aber abgesehen von wesentlich höheren Kosten für die Herstellung und den Betrieb von Lasern gegenüber den bisher erwähnten Energiequellen ist der in der Produktion erreichbare Durchsatz in den meisten Fällen viel zu gering. Der Einsatz mehrerer Laser zur Erhöhung des Durchsatzes ist i.a. aus Kostengründen nicht vertretbar, insbesondere da die Laser miteinander koordiniert werden müssten. Zusätzlich ergeben sich andere Temperaturprofile durch Laser aufgrund deren punktförmige Einwirkung und daraus folgenden Temperaturprofile auf dem Substrat im Gegensatz zu der flächenhaften Einwirkung von Feldern parallel angeordneter Blitzlampen oder Halogenlampen bzw. Infrarotstrahlern. Die unterschiedlichen Temperaturprofile können verschiedene Auswirkungen auf das Resultat der thermischen Behandlung des Substrats nach sich ziehen.

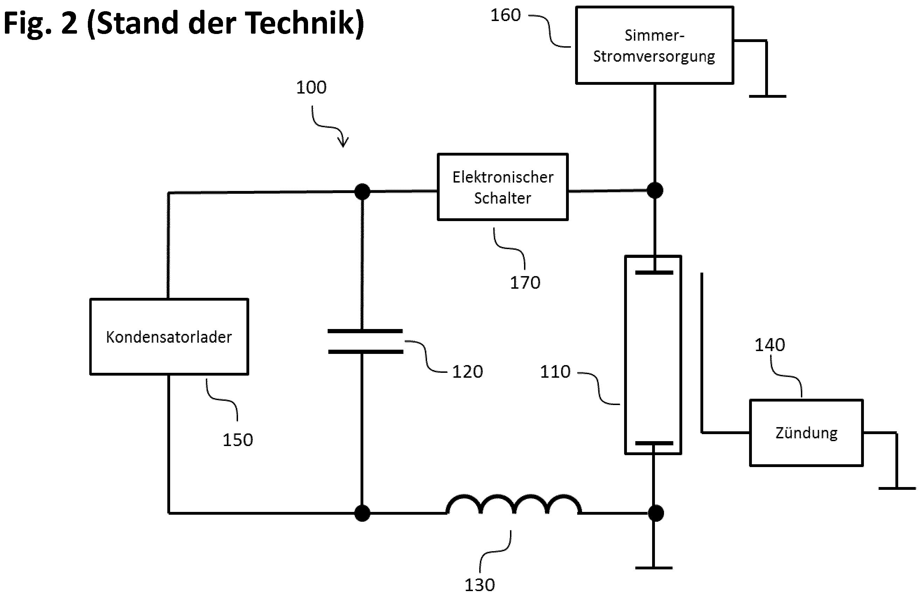

Die Figur 2 zeigt den Stand der Technik einer Vorrichtung (100), die zum Betrieb von Blitzlampen in der Produktion üblich ist. Grundsätzlich besteht ein Schaltkreis aus einer Blitzlampe (110), einem Kondensator (120) als Energiequelle und einer Drosselspule (130) zur Strombegrenzung. Zur Zündung der Blitzlampe ist eine separate Stromversorgung (140) notwendig, die in der Figur als sogenannte "externe Zündung" ausgeführt ist. Eine externe Zündung besteht beispielsweise aus einem optischen Reflektor aus Metall, der um die Blitzlampe angeordnet ist und mit der Stromversorgung der Zündung elektrisch verbunden ist. Andere Zündungsvarianten werden ebenso eingesetzt in Abhängigkeit von der Anwendung der Blitzlampen.

Bei der Verwendung von Blitzlampen zum optischen pumpen von Lasern hat sich herausgestellt, dass die Lebensdauer der Blitzlampen erhöht werden kann, wenn sie im Standby-Modus durch eine sogenannte Simmer-Stromversorgung betrieben werden. Simmer - englisch für "köcheln" - sind Stromversorgungen, die einen dünnen Plasmafaden in der Blitzlampe ähnlich einem Zündfunken am Brennen halten. Beispielsweise beträgt der Simmer-Strom durch die Blitzlampe 0,5 Ampere nach der Zündung der Blitzlampe. Zur Umschaltung in den eigentlichen Betriebsmodus der Blitzlampe muss zuvor durch eine Stromversorgung (150) der Kondensator (120) geladen werden. Anschließend wird über einen elektronischen Schalter (170) der Kondensator (120) über die Blitzlampe (110) entladen. Der Strom kann im Betriebsmodus mehrere 100 bis mehrere 1000 Ampere betragen, je nach Ausführungsform und gewünschter Lichtintensität der Blitzlampe. Typischerweise beträgt die Pulsdauer der Entladung im Betriebsmodus der Blitzlampen zwischen 50 Mikrosekunden und 20 Millisekunden, wobei der Strom durch die Blitzlampe in Bezug auf die Zeit die Form einer Gaußglocke annimmt. Der Entladevorgang des Kondensators kann dabei durch den elektronischen Schalter (170) zu einem beliebigen Zeitpunkt gestoppt werden.

Die Druckschrift US20100111513A1 zeigt auf Figuren 6 und 9 ein Verfahren und eine Vorrichtung gemäß dem Oberbegriff des Anspruchs 1 bzw. 4.

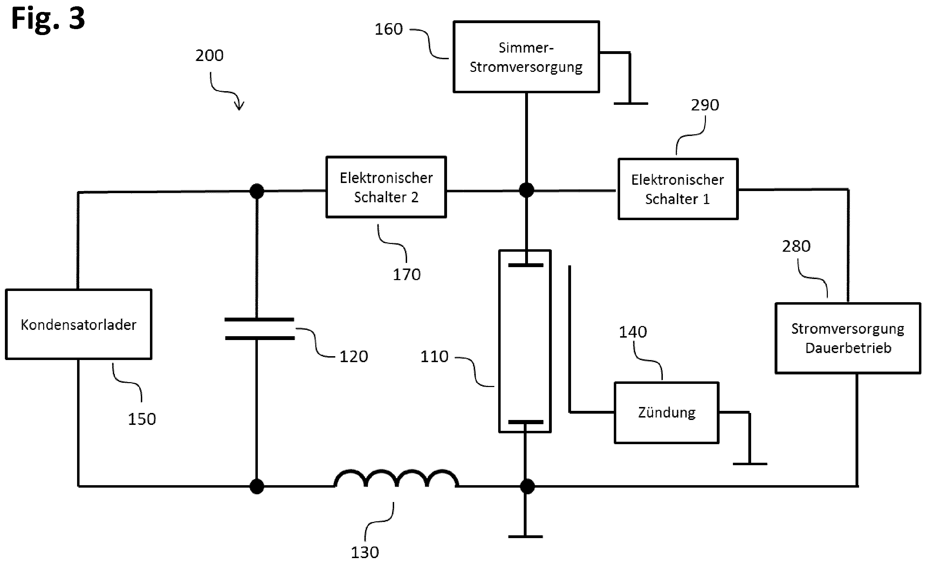

Figur 3 zeigt eine Erweiterung gegenüber der Vorrichtung (100) gemäß der Erfindung, welche aus einem zusätzlichen elektronischen Schalter 1 (290) und einer zusätzlichen Stromversorgung (280) besteht. Die Stromversorgung (280) kann in einfachster Bauweise ein Streufeldtransformator sein, der für eine ausreichend hohe Leerlaufspannung in Abhängigkeit von der Lichtbogenlänge der Blitzlampe (110) konzipiert ist und einen manuell und mechanisch einstellbaren Kurzschlussstrom aufweist. Manuell und mechanisch einstellbare Streufeldtransformatoren werden auch zum elektrischen Schweißen von Metallen verwendet. Der Ausgang des Transformators wird über einen Gleichrichter mit dem elektronischen Schalter und der Masseleitung verbunden. Typische Ausgangsströme für die Stromversorgung (280) betragen 10 bis 100 Ampere. Im Gegensatz zum Kondensator (120) liefert der Streufeldtransformator einen konstanten Strom, sodass die Blitzlampe (110) als kontinuierliche brennende Gasentladungslampe betrieben werden kann, allerdings mit einer um ein bis mehrere Größenordnungen geringeren Leistung gegenüber dem Kondensator (120) bzw. entsprechend der Stärke des Stroms durch die Blitzlampe. Alternative Stromversorgungen zu einem Streufeldtransformator wie z.B. Schaltnetzteile sind ebenso geeignet.

Zur Vermeidung von kurzzeitigen und sehr hohen Leistungsanforderungen an das öffentliche Stromnetz für die Stromversorgung (280) können Akkumulatoren als Puffer eingesetzt werden. Beispielsweise kann durch eine Serienschaltung vieler Akkumulatoren, die zum Start eines Automobils verwendet werden, eine Spannung im Bereich von mehreren hundert bis mehreren tausend Volt erzeugt werden bei Strömen über 1000 Ampere. Die chemische Reaktionszeit des Akkumulators liegt typischerweise im Bereich von wenigen Mikrosekunden, sodass Belichtungszeiten im Zeitraum von einer Millisekunde bis mehrere Sekunden problemlos realisiert werden können. Die Akkumulatoren werden bei einer kontinuierlichen Leistungsentnahme aus dem öffentlichen Netz zwischen zwei aufeinanderfolgende Belichtungen geladen, die einen zeitlichen Abstand von beispielsweise 30 Sekunden haben.

Mit dem elektronischen Schalter 1 (290) kann die Lampe (110) gleich schnell an- und ausgeschaltet werden wie mit dem elektronischen Schalter 2 (170), sodass die Belichtungszeit nahezu beliebig kurz eingestellt werden kann ohne signifikante Verzögerungen während des Ein- oder Ausschaltvorgangs wie dies bei Halogenlampen oder Infrarotlampen der Fall ist.

Ein wichtiger und begrenzender Faktor ist die Kühlung der Lampe, z.B. mit Luft oder Wasser. Es darf zu keinem Zeitpunkt das Quarzglas der Blitzlampe oder die hauptsächlich aus Wolfram bestehenden Elektroden der Blitzlampe schmelzen. Es können aber kurzzeitig zur thermischen Behandlung eines Substrats für eine Dauer von z.B. 500 Millisekunden Ströme eingestellt werden, die weit über den maximalen Strömen im Dauerbetrieb liegen ähnlich wie bei Blitzlampen.

Beide elektronische Schalter (170), (290) können prinzipiell zu jedem beliebigen Zeitpunkt und unabhängig voneinander geschlossen oder geöffnet werden. Für eine thermische Behandlung eines Substrats sind aber nur folgende drei Varianten praxisrelevant: a) es wird ausschließlich der Elektronische Schalter 1 (290) für eine gewünschte Zeit lang geschlossen und anschließend wieder geöffnet, b) es wird ausschließlich der elektronische Schalter 2 (170) geschlossen, wobei die maximale thermische Behandlungszeit des Substrats von der Kapazität des Kondensators abhängt, c) am Ende einer gewünschten Belichtungszeit des Substrats mit der Lampe (110) unter Verwendung der Stromversorgung (280) wird der elektronische Schalter 2 (170) geschlossen und dabei ungefähr zur gleichen Zeit die Stromversorgung der Lampe über das Öffnen des elektronischen Schalter 1 (290) von der Stromversorgung für den Dauerbetrieb (280) getrennt, sodass es zu einem Temperaturverlauf ähnlich dem "flash lamp assisted spike annealing" kommt. Dabei erfolgt die Erwärmung allerdings immer von einer Seite, beispielsweise von der Stirnseite des Substrats.

Die Vorrichtung in Figur 3 bietet gegenüber Blitzlampen und/oder Halogenlampen bzw. Infrarotlampen zusätzlich Belichtungszeiten im Bereich zwischen FLA und RTP gemäß Figur 1, d.h. zwischen ungefähr 20 Millisekunden und ungefähr 500 Millisekunden. Außerdem können höhere Lichtleistungen der Lampe (110) im Vergleich zu Halogen- oder Infrarotlampen erreicht werden, auch für RTP übliche Belichtungszeiten. Weiterhin ist nur eine einzige Art von Lampen zur thermischen Behandlung Substrats erforderlich im Vergleich zum "flash lamp assisted spike annealing".

### Verfahren und Vorrichtung zur thermischen Behandlung eines Substrats.

### Bezugszeichenliste

- 100:: Vorrichtung gemäß Stand der Technik
- 110:: Gasentladungslampe
- 120:: Kondensator
- 130:: Drosselspule
- 140:: Stromversorgung für Zündung
- 150:: Stromversorgung zur Ladung des Kondensators
- 160:: Stromversorgung für Simmer-Betrieb
- 170:: Elektronischer Schalter 2
- 200:: Vorrichtung gemäß der Erfindung
- 280:: Stromversorgung mit konstanter Leistung für Dauerbetrieb
- 290:: Elektronischer Schalter 1

## Patentansprüche

1. Verfahren zur thermischen Behandlung eines Substrats mit mindestens einer Gasentladungslampe (110), in dem in einem Betriebsmodus ein zuvor über eine Stromversorgung (150) geladener Kondensator (120) über die Gasentladungslampe (110) entladen wird, **dadurch gekennzeichnet, dass** die Gasentladungslampe (110) für einen ersten Zeitraum mit einer Dauer von 20 Millisekunden bis 5 Sekunden bei einer konstanten elektrischen Leistung mit einer gegenüber dem Betriebsmodus um mindestens eine Größenordnung geringeren Leistung betrieben wird und am Ende des ersten Zeitraums die mittlere elektrische Leistung der Gasentladungslampe für einen zweiten Zeitraum mit einer Dauer von 50 Mikrosekunden bis 20 Millisekunden um mindestens eine Größenordnung erhöht wird.

2. Verfahren gemäß Anspruch 1,
wobei das Substrat eine Beschichtung aufweist mit einer Dicke von 2 bis 200 Mikrometern.

3. Verfahren gemäß Anspruch 2,
wobei die Beschichtung aus mindestens einem Sol-Gel Film, aus einer Lackierung, aus Nanopartikeln besteht.

4. Vorrichtung zur thermischen Behandlung eines Substrats mit mindestens einer Gasentladungslampe (110), welche einen Simmer-Betrieb im Standby-Modus aufweist und die in einem Betriebsmodus über einen ersten elektronischen Schalter (170) mit mindestens einem elektrisch geladenen Kondensator (120) verbindbar ist, **dadurch gekennzeichnet, dass** die Gasentladungslampe über einen zweiten elektronischen Schalter (290) mit einer Stromversorgung (280) mit einer gegenüber dem Betriebsmodus um mindestens eine Größenordnungen geringeren konstanten Leistung für eine Dauer von 20 Millisekunden bis 5 Sekunden verbindbar ist.

5. Vorrichtung gemäß Anspruch 4,
wobei die erste Stromversorgung (280) einen Streufeldtransformator und einen Gleichrichter enthält.

6. Vorrichtung gemäß Anspruch 5,
wobei die maximale Stromstärke des Streufeldtransformators manuell über einen mechanischen Regler einstellbar ist.

7. Vorrichtung gemäß Anspruch 4,
wobei die erste Stromversorgung (280) mindestens einen Akkumulator enthält.

## Claims

1. Method for the thermal treatment of a substrate using at least one gas discharge lamp (110), in which a capacitor (120) previously charged by way of a power supply (150) is discharged via the gas discharge lamp (110) in one mode of operation, **characterized in that** the gas discharge lamp (110) is operated for a first period of time having a duration of 20 milliseconds to 5 seconds at a constant electrical power with a power that is lower by at least one order of magnitude vis-à-vis the mode of operation, and at the end of the first period of time the average electrical power of the gas discharge lamp is increased by at least one order of magnitude for a second period of time having a duration of 50 microseconds to 20 milliseconds.

2. Method according to Claim 1,
wherein the substrate has a coating having a thickness of 2 to 200 micrometres.

3. Method according to Claim 2,
wherein the coating consists of at least one sol-gel film, a lacquer, or of nanoparticles.

4. Device for the thermal treatment of a substrate using at least one gas discharge lamp (110), which has a simmer operation in the standby mode and which in one mode of operation is connectable to at least one electrically charged capacitor (120) via a first electronic switch (170), **characterized in that** the gas discharge lamp is connectable via a second electronic switch (290) to a power supply (280) of a constant power that is lower by at least one order of magnitude vis-à-vis the mode of operation, for a period of 20 milliseconds to 5 seconds.

5. Device according to Claim 4,
wherein the first power supply (280) contains a stray field transformer and a rectifier.

6. Device according to Claim 5,
wherein the maximum current strength of the stray field transformer is adjustable manually via a mechanical regulator.

7. Device according to Claim 4,
wherein the first power supply (280) contains at least one rechargeable battery.

## Revendications

1. Procédé de traitement thermique d'un substrat à l'aide d'au moins une lampe à décharge gazeuse (110), procédé dans lequel, dans un mode de fonctionnement, un condensateur (120) préalablement chargé par le biais d'une alimentation en courant (150) est déchargé par le biais de la lampe à décharge gazeuse (110), **caractérisé en ce que** la lampe à décharge gazeuse (110) fonctionne pendant un premier intervalle de temps d'une durée de 20 millisecondes à 5 secondes à une puissance électrique constante avec une puissance inférieure d'au moins un ordre de grandeur par rapport au mode de fonctionnement et à la fin du premier intervalle de temps la puissance électrique moyenne de la lampe à décharge gazeuse est augmentée d'au moins un ordre de grandeur pendant un deuxième intervalle de temps d'une durée de 50 microsecondes à 20 millisecondes.

2. Procédé selon la revendication 1,
le substrat comportant un revêtement d'une épaisseur de 2 à 200 microns.

3. Procédé selon la revendication 2,
le revêtement comprenant au moins un film sol-gel, un vernis, des nanoparticules.

4. Dispositif de traitement thermique d'un substrat à l'aide d'au moins une lampe à décharge gazeuse (110) qui comporte un fonctionnement minimal en mode veille et qui peut être reliée dans un mode de fonctionnement à au moins un condensateur chargé électriquement (120) par le biais d'un premier commutateur électronique (170), **caractérisé en ce que** la lampe à décharge gazeuse peut être reliée pendant une durée de 20 millisecondes à 5 secondes, par le biais d'un deuxième commutateur électronique (290), à une alimentation en courant (280) ayant une puissance constante qui est inférieure d'au moins un ordre de grandeur par rapport au mode de fonctionnement.

5. Dispositif selon la revendication 4,
la première alimentation en courant (280) comprenant un transformateur à champ de fuite et un redresseur.

6. Dispositif selon la revendication 5,
l'intensité de courant maximale du transformateur à champ de fuite étant réglable manuellement par le biais d'un régulateur mécanique.

7. Dispositif selon la revendication 4,
la première alimentation en courant (280) comprenant au moins un accumulateur.
